# EUROPEAN PATENT APPLICATION

(11) **EP 0 841 575 A2**
(43) Date of publication of application: **13.05.1998**
(21) Application number: 97308477.5
(22) Date of filing: 23.10.1997
(51) Int. Cl.: G01R 33/34

(54) **Magnetic resonance imaging**

(30) Priority: 12.11.1996 GB 9623543; 10.03.1997 GB 9704882
(71) Applicant: GEC-Marconi Limited, Stanmore Middlesex HA7 4LY (GB)
(72) Inventor: Gilderdale, David John, Bovey Tracey, South Devon TQ13 9LF (GB)
(74) Representative: Waters, Jeffrey

(57) **Abstract**

A re-usable prostate coil, for use with magnetic resonance imaging to improve the signal to noise ratio, comprises a rigid handle portion by which the coil may be inserted into and withdrawn from an operative position within the patient, and a rigid coil supporting portion integral with the handle portion, a rectangular coil loop being carried by the coil supporting portion and at least a part of the handle portion having a width which is less than that of the rectangular coil loop.

## Description

This invention relates to magnetic resonance imaging (MRI).

Magnetic resonance imaging is used in medicine to produce images of the internal organs of a patient being examined. In MRI, a static magnetic field is applied to the body of the patient to define an equilibrium axis of magnetic alignment in the region of the body being examined. A radio frequency field is then applied to the region being examined in a direction orthogonal to the static magnetic field direction to excite magnetic resonance in the region. This resonance produces signals in RF coils placed adjacent the body. Normally separate coils are used for excitation and detection, although the same coil or coils may be used for both purposes. The detected signals are processed to produce signals representing an image of the patient's body and this image is visually displayed. In so-called interventional MRI, RF coils are introduced into the body.

The invention particularly relates to re-usable prostate coils for use in MRI.

It is now well established that signal to noise ratio (SNR) in magnetic resonance imaging (MRI) may be increased by the use of small local coils, albeit using a smaller field of view (FOV). This approach is used routinely for imaging of the prostate, see Schiebler M.L., Schnall M.D., Pollack H.M. et al, Radiology 189, pages 339-352, 1993, and US-A-5 476 095, wherein a disposable, inflatable coil, mounted on a semi-flexible handle is used.

These coils require a complex and costly system for remotely tuning and matching with each patient. The need for individual coil tuning and matching for each patient adds a significant time to each examination. An additional cost for each disposable coil must be included for each examination. Further, the flexibility of the structure allows coil movement, with resulting image artefact.

It has been proposed (US-A-5 170 789) to provide a probe with a rigid coil supporting portion and a rigid handle but, unless a relatively small coil is used, the probe would be unsuitable for insertion into smaller body orifices such as the rectum which is used for imaging the prostate. The coil is tuned remotely when in situ, using tuning rods which extend through the handle.

The invention provides a re-usable prostate coil, for use in magnetic resonance imaging, comprising a rigid handle portion by which the coil may be inserted into and withdrawn from an operative position within the patient, a rigid coil supporting portion integral with the handle portion, a rectangular coil loop being carried by the coil supporting portion, wherein at least a part of the handle portion has a width which is less than that of the rectangular coil.

The reduced width portion permits the re-usable prostate coil to be maintained in the rectum with reasonable comfort sufficiently long to enable imaging to be performed, without having to use a coil of undesirably small size.

Advantageously the handle portion and coil supporting portion are moulded integrally from a plastics material. Preferably the coil supporting portion has a substantially flat surface in which the coil is mounted.

In order to further increase the signal to noise ratio, a second rectangular coil loop may be carried by the coil supporting portion, the second coil loop partly overlapping the first coil loop to reduce coupling between the two loops.

In order to decouple the rectangular coil loop or loops from the RF excitation pulse, the coil may be connected by a transmission line to means such as a PIN diode which can be short circuited, in order to selectively open circuit the coil loop or loops.

Re-usable prostate coils for use in magnetic resonance imaging constructed in accordance with the invention will now be described, by way of example, with reference to the accompanying drawings, in which:
Figure 1a is a side elevation of the former for a first re-usable prostate coil, together with a corresponding end elevation;
Figure 1b is a plan view of the former shown in Figure 1a, together with the corresponding end elevation;
Figure 2 shows the first re-usable prostate coil resting on a surface;
Figure 3 is a plan view of the first re-usable prostate coil;
Figure 4 shows the electrical circuit, partly in schematic form, of the prostate coil of Figures 1 to 3;
Figure 5 is a plan view of a second re-usable prostate coil;
Figure 6 shows the variation of signal to noise ratio of the first coil and second coil taken in a longitudinal direction along the probe; and
Figure 7 shows the variation of signal to noise ratio of the second coil and the first coil taken in a transverse direction.

Like parts are given like reference numerals throughout all the figures.

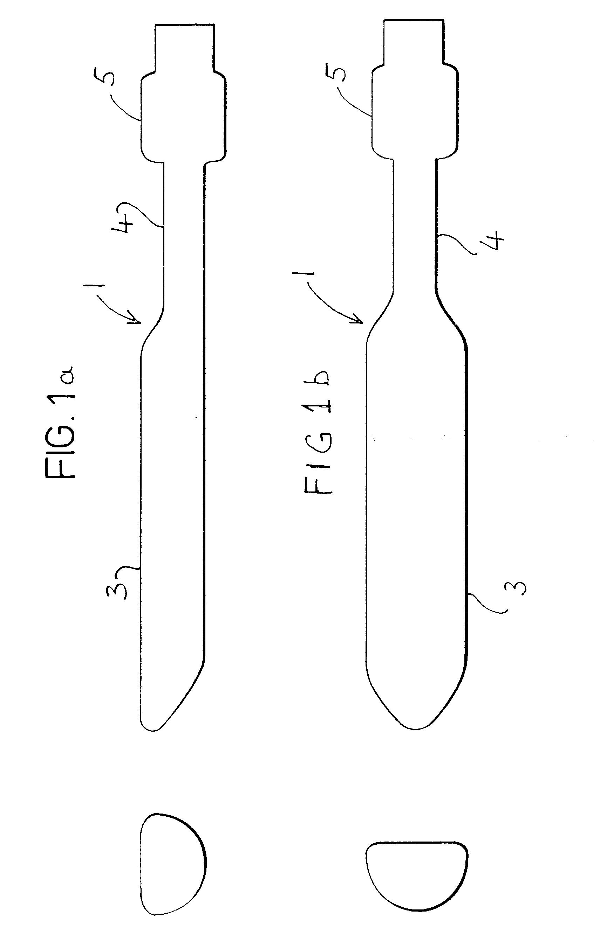

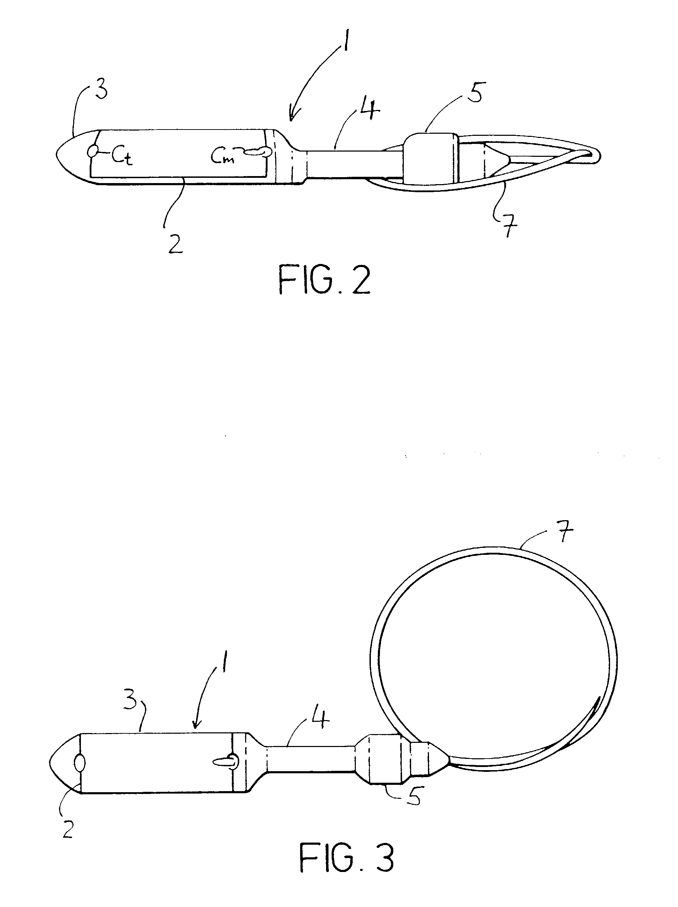

The first re-usable prostate coil, shown with reference to Figures 1a, 1b and 2 to 4 has a solid coil former 1. The coil comprises a single rectangular loop 2, mounted on the former as shown in Figures 2 and 3. The coil is mounted adjacent to the flattened surface which is positioned against the posterior surface of the prostate in use when the rigid coil supporting portion is inserted into the rectum of a patient, maximising SNR, particularly in the posterior of the peripheral lobes. The solid former may be clamped externally to minimise motion artefact.

The solid coil former 1 comprises a substantially hemi-cylindrical rigid coil supporting portion 3 which is integral with a rigid handle portion 4, both parts being made of plastics material. The rigid handle portion 4 is integral with a portion 5 of increased diameter, which houses a PIN diode 6 (the purpose of which will be explained hereinafter), and a cable 7 extends from the end of the handle portion and is connected to a low impedance pre-amplifier of MRI processing electronics (not shown).

The coil loop 2 is rectangular in order to provide the greatest area of loop in order to provide the best signal to noise ratio at the distance appropriate for the prostate gland, and is inset into the surface of the former so that it is just visible at the surface. The coil supporting portion 3 is substantially flat, and the edges of the coil supporting portion are all smooth and rounded to facilitate insertion into a body cavity.

In the plan view shown in Figure 3, the width of the rigid handle portion is less than the width of the rectangular coil, as is the height of the handle portion less than the height of the coil supporting portion in elevation (Figure 1a), the handle portion being cylindrical, in order to provide a reduced diameter region corresponding to the anal sphincter muscle. A typical scan time with the coil in situ of the re-usable prostate coil would be of the order of thirty minutes to an hour.

In use of the re-usable prostate coil, the solid former would be clamped externally to minimise motion artefact in the MR images produced.

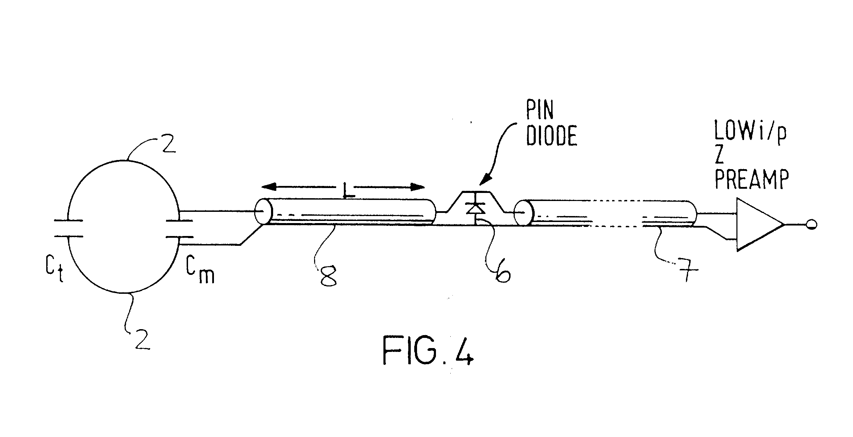

A tuning capacitance Cₜ and a matching capacitance Cₘ are connected at opposite narrow ends of the rectangular coil, and are embedded in the coil former so that there is an unbroken smooth surface. The rigid handle portion 4 is hollow to accommodate a transmission line of length L 8, the purpose of which will now be described with reference to Figure 4. The purpose of tuning capacitor Cₜ is to tune the coil loop to the magnetic resonance frequency, and the purpose of the matching capacitor Cₘ is to match the coil loop at resonance to the 50 ohm impedance of the cable 8. Cₜᵤₙₑ is much less than C_{match}, so that Cₜᵤₙₑ dominates the tuning adjustment. Cₜᵤₙₑ is positioned at the mid-way point of the inductance of the coil loop. Since C_{match} is much greater than Cₜᵤₙₑ, most of the potential distributed around the coil is across Cₜᵤₙₑ. Thus, grounding one side of C_{match} has little effect on the balance of potentials with respect to ground, minimising dielectric losses in body tissue. C_{match} is adjusted so that the impedance seen across C_{match} with the coil loaded i.e. when inserted in a patient, is 50 ohms.

Both components Cₜᵤₙₑ and C_{match} are adjusted during manufacture of the prostate coil, so that there are no adjustments needed when the prostate coil is inserted into the body. This significantly shortens and simplifies the pre-scan preparation time for the patient.

In order to isolate the rectangular coil loop during the RF excitation pulse, the coil being receive only, a PIN diode 6 is provided which can be controlled to produce a short circuit by switching forward current through the diode. Length L of low-loss semi-rigid coaxial cable 8 combines with Cₘ to form a resonant circuit to produce a high impedance in series with the coil loop, thereby detuning it and isolating it.

For the convenience of allowing the re-usable prostate coil to be movable to some extent relative to the processing electronics, a half wavelength length 7 of flexible coaxial cable connects the PIN diode 6 to the low input (-5 ohms) input impedance preamplifier. The preamplifier input circuit is series tuned with the flexible coaxial cable so that the low input impedance is transformed to the position of the PIN diode. Such a deliberate mismatch is chosen since the signal current in the rectangular loop 2 is reduced, thereby reducing coupling to other coils, without affecting the signal to noise ratio, since noise is reduced in the same proportion. This has the effect of reducing the Q of the coil without significant SNR loss, but reduces the coupling of noise to and from other coils. The circuit thus performs a number of functions with the minimum of components.

Typically the width of the rectangular coil will be at least 20mm, and its length will be at least 40mm, whereas the reduced diameter of the handle will be half the width of the coil or less.

The solid coil structure provides advantages for the electronic design. Experience has shown that the body loss is introduced when the coil is in use and is reasonably consistent from patient to patient. Hence the tuning and matching adjustment, necessary due to the geometric variability of an inflatable coil is completely avoided.

The second re-usable prostate coil is the same as the first, except that two rectangular coil loops 9, 10 are provided in place of the one of the first re-usable prostate coil.

Each coil loop 9, 10 is the same as the coil loop 2, except having a smaller length (the width is the same), and dual circuits of the kind shown in Figure 4 and MRI processing channels are accordingly necessary. The shorter coil is better for the depths in question (imaging the prostate from the rectal passage), while two coils are needed to cover the full field of view. Processing electronics combine the signals from the two channels to form a single image. The degree of overlap of the coil loops is set critically to cancel the coupling i.e. the mutual inductance between the two loops. In this way, noise coupling between the two coil loops is largely eliminated.

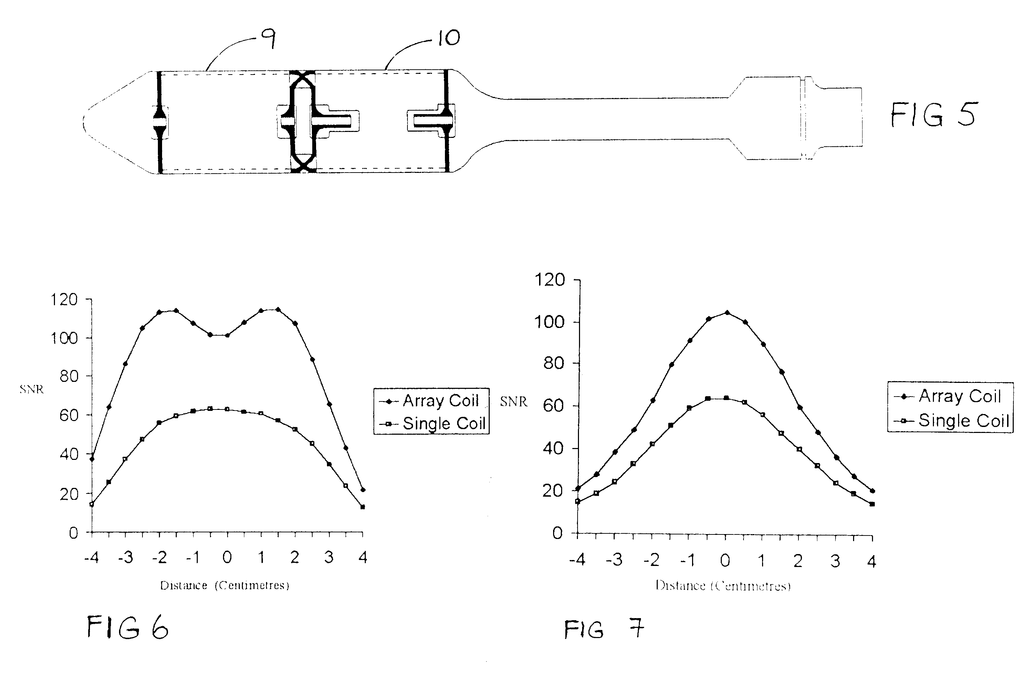

The solid coil former lends itself particularly to the use of two coils, which have to maintain an accurate juxtaposition. A rectangular coil produces an optimum SNR to certain depth. In fact the shorter length of each of the overlapping coils (the overall dimensions of the former being unchanged from Figures la, 1b and 3) actually gives improved SNR from the prostate. The improvement in SNR can be seen from Figures 6 and 7, wherein each case the upper curve is the SNR of the second re-usable prostate coil while the lower curve is the SNR of the first re-usable prostate coil.

Figure 6 shows the variation of SNR with distance along the central long axis of the coil former from an image plane parallel to, but 2cm above the plane of the coil, whereas Figure 7 shows the variation of SNR along the central short axis of the coil former.

The coil former may be made from acetyl homopolymer (Delrin). Typical dimensions for the single rectangular coil are approximately 25 mm by 66 mm and for the overlapping rectangular coils are approximately 25 mm by 36 mm, with the coils overlapped by approximately 6 mm.

Three coils may be used in place of the two shown in Figure 5, the coils overlapping to reduce or cancel the coupling between the coils.

The rigid coil structure along with the inductance and capacitance values used allows for factory pre-tuning and matching, eliminating any need for these adjustments to be carried out with the coil in position. This significantly simplifies and shortens the procedure for pre-scan patient preparation. The embodiments are especially suited to so-called interventional magnets i.e. open magnets, where the field strength is typically in the region of 0.5 Tesla, and the corresponding resonant frequency would be in the region of 21 MHz, say, less than 25 MHz.

In both embodiments, tuning capacitors should be at least 50 pF, preferably of the order of 250 pF, whether one tuning capacitor is used in the loop or whether the tuning capacitors are distributed around the loop. Such values would be significantly greater than stray capacitances encountered when the coil is inserted, which could be of the order of 5 pF, to avoid de-tuning of the coil.

The coils illustrated are intended for receive only operation i.e. separate coils are provided for the r.f. excitation pulse. However, the coils could be used for transmit/ receive, or transmit only, i.e. the coil itself would provide the r.f. excitation pulse, in which case the de-tuning circuitry (the transmission line 8 and PIN diode 6 would be omitted).

## Claims

1. A re-usable prostate coil, for use in magnetic resonance imaging, comprising a rigid handle portion by which the coil may be inserted into and withdrawn from an operative position within the patient, a rigid coil supporting portion integral with the handle portion, a rectangular coil loop being carried by the coil supporting portion, wherein at least a part of the handle portion has a width which is less than that of the rectangular coil.

2. A coil as claimed in Claim 1, in which the rigid handle portion is moulded integrally with the rigid coil supporting portion from plastics material.

3. A coil as claimed in Claim 1 or Claim 2, in which the coil supporting portion has a substantially flat surface.

4. A coil as claimed in any one of Claims 1 to 3, in which a pre-tuned tuning capacitor for the rectangular coil is carried by the coil supporting portion.

5. A coil as claimed in any one of Claims 1 to 4, in which the said part of the handle portion is cylindrical, the diameter being less than the width of the rectangular coil.

6. A coil as claimed in Claim 5, in which the diameter is approximately 10 mm.

7. A coil as claimed in any one of Claims 1 to 6, wherein the coil loop is loaded by a transmission line, the end of which remote from the coil loop can be short circuited in order to detune the coil loop.

8. A coil as claimed in Claim 7, including a PIN diode to permit the transmission line to be short circuited.

9. A coil as claimed in any one of Claims 1 to 8, wherein the dimensions of the coil loop are substantially 25 mm by 66 mm.

10. A coil as claimed in any one of Claims 1 to 9, including a second rectangular coil loop carried by the coil supporting portion, the second coil loop partly overlapping the first coil loop to reduce the coupling between the two loops, the coils being connected to separate channels of magnetic resonance imaging processing means, the processing means combining the signals from the channels to form a single image.

11. A coil as claimed in any one of Claims 1 to 9, including a second rectangular coil loop carried by the coil supporting portion, the second coil loop partly overlapping the first coil loop to reduce the coupling between the two loops, the dimensions of each loop being substantially 25 mm by 36 mm.

12. A coil as claimed in any one of Claims 1 to 11, which is rigidly clamped in position during use.
